**Europäisches Patentamt**

**European Patent Office**

**Office européen des brevets**

(19)

(11) Veröffentlichungsnummer : **0 070 417**
**B1**

(12)

# EUROPÄISCHE PATENTSCHRIFT

(45) Veröffentlichungstag der Patentschrift :
26.03.86

(51) Int. Cl.⁴ : **H 03 H   9/05, H 03 H   9/09**

(21) Anmeldenummer : **82105627.2**

(22) Anmeldetag : **25.06.82**

(54) **Halterung für eine Schwingquarzscheibe.**

(30) Priorität : **02.07.81 DE 3126077**
**02.07.81 DEU 8119317**

(43) Veröffentlichungstag der Anmeldung :
**26.01.83 Patentblatt 83/04**

(45) Bekanntmachung des Hinweises auf die Patenterteilung : **26.03.86 Patentblatt 86/13**

(84) Benannte Vertragsstaaten :
**AT CH FR GB IT LI NL**

(56) Entgegenhaltungen :
**CH-A-   443 418**
**DE-A- 2 019 389**
**GB-A-   588 452**
**US-A- 2 471 625**
**US-A- 2 850 651**
**US-A- 3 022 431**

(73) Patentinhaber : **Schott Glaswerke**
**Hattenbergstrasse 10**
**D-6500 Mainz (DE)**

(72) Erfinder : **Fuchs, Dieter, Dr. Dipl.-Phys.**
**Bussardstrasse 26**
**D-8300 Landshut (DE)**
Erfinder : **Ertel, Gerhard**
**Heinzelwinkelstrasse 17**
**D-8311 Tiefenbach (DE)**
Erfinder : **Heimerl, Dieter**
**Wilhelm-Hauff-Strasse 48**
**D-8300 Landshut (DE)**

(74) Vertreter : **Rasper, Joachim, Dr.**
**Bierstadter Höhe 22**
**D-6200 Wiesbaden (DE)**

**Beschreibung**

Die Erfindung betrifft eine Halterung für eine im wesentlichen rechteckige Schwingquarzscheibe, bestehend aus einer Bodenplatte mit zwei Stromdurchführungsstiften, an deren oberen Enden jeweils eine aufragende Blattfeder befestigt ist, welche die Schwingquarzscheibe in einem Randbereich auf gegenüberliegenden Seiten der Scheibenebene übergreifen und dadurch ihre Bewegungen in der und quer zur Scheibenebene begrenzen.

Aus der DE-C-26 51 094 ist eine Halterung bekannt, bei der jede Blattfeder einen dem Stromdurchführungsstift benachbarten inneren Befestigungsabschnitt und einen äußeren Befestigungsabschnitt jeweils mit zwei Randstreifen aufweist, welche die im wesentlichen rechteckförmige Schwingquarzscheibe in einem unteren bzw. oberen Eckbereich übergreifen, so daß die Schwingquarzscheibe an ihren vier Ecken durch die beiden Blattfedern gehalten ist. Jede Blattfeder ist in einem mittleren Bereich etwa rechtwinklig abgebogen und mit einem einzigen Längsschlitz versehen, der sich über beide Blattfederschenkel zwischen dem inneren Befestigungsabschnitt und dem äußeren Befestigungsabschnitt erstreckt. Die Scheibenecken sind mit einer Schrägfläche versehen, die etwa rechtwinklig zu dem zugehörigen Blattfederschenkel verläuft, aus dem ein kurzer Lappen ausgeklinkt ist, der mit seinem abgebogenen freien Ende an der Schrägfläche anliegt. Die Elektrodenflächen auf einander gegenüberliegenden Seiten der Schwingquarzscheibe sind mit Kontaktabschnitten zu den Schrägflächen geführt, die den äußeren Befestigungsabschnitten der Blattfedern zugeordnet sind, und deren Befestigungslappen weisen im Anlagebereich ein Loch auf, das mit einem Leitkitt ausgefüllt ist.

Bei dieser bekannten Ausbildung übergreifen die beiden Blattfedern nicht nur den Scheibenrand, sondern sind mit ihrer die Abwinklung aufweisenden Längsmitte in geringem Abstand zueinander in mittlerer Höhe der Schwingquarzscheibe angeordnet und hier mit ihren Randstreifen den Elektrodenflächen benachbart. Zur Vermeidung von Berührungen an dieser Stelle müssen ein vergleichsweise breiter Längsschlitz und stabile Randstreifen vorgesehen sein. Aus diesem Grunde sowie im Hinblick auf die Versteifungswirkung, die von der Blattfederabwinklung ausgeht, sind der innere Befestigungsabschnitt und der äußere Befestigungsabschnitt einer jeder Blattfeder vergleichsweise starr zueinander fixiert. Dieses wirkt sich nachteilig für die erstrebte möglichst spannungsfreie und elastische Aufhängung der Schwingquarzscheibe aus, mit der die Übertragung von mechanischen Beanspruchungen durch dilathermische Kräfte zwischen der Halterung und der Schwingquarzscheibe weitgehend vermieden und eine hohe Unempfindlichkeit gegen Stoß- und Vibrationsbelastungen erreicht werden soll.

Es ist auch bereits bekannt, bei einer Halterung für die Abstützung einer Schwingquarzscheibe in ihren vier Ecken jeweils den inneren und den äußeren Befestigungsabschnitt, die durch ein V-Profil gebildet sind, durch einen Verbindungsabschnitt miteinander zu verbinden, der sich längs des Scheibenrandes geradlinig zwischen den beiden Befestigungsabschnitten erstreckt (DE-PS-27 37 034). Dieser Verbindungsabschnitt weist gleichfalls ein V-Profil auf, das jedoch einen größeren Öffnungswinkel aufweist, um den Abstand zum Scheibenrand zu erreichen. Die Profilierung macht jedoch den Verbindungsabschnitt ziemlich steif, so daß auch hier jeweils der innere und der äußere Befestigungsabschnitt ziemlich starr miteinander verbunden sind und es daher an der wünschenswerten elastischen Eckpunktaufhängung fehlt.

Es ist ferner eine Halterung der eingangs genannten Art für eine kreisförmige Schwingquarzscheibe bekannt (DE-OS-20 19 389).

Dort weisen die beiden Blattfedern jeweils einen einzigen Befestigungsabschnitt mit einer ausgestanzten Längsaussparung auf, die von zwei Randstreifen flankiert ist, die als halbkreisförmige Bögen einwärts in Richtung auf die Scheibenmitte vorspringen. Die Längsaussparungen sind an ihren Enden v-förmig ausgebildet und von einer scharfen Stanzkante umgrenzt. Die mit ihrem Rand durch die beiden Längsaussparungen ragende Schwingquarzscheibe berührt die beiden Blattfedern jeweils an den Enden der Längsaussparungen. Hierbei kommt es zu einer punktförmigen Anlage mit den Stanzkanten, wobei von den Blattfedern eine Vorspannkraft auf die Schwingquarzscheibe übertragen wird. Diese Halterung der Scheibe mit punktförmiger Anlage an scharfen Stanzkanten führt zu örtlichen Spannungsbeanspruchungen der Scheibe, die in erhöhtem Maße mechanischen Beschädigungen bei der Montage und danach durch Stoß- und Vibrationsbelastungen ausgesetzt ist.

Aus der GB-A-588 452 ist die im Oberbegriff von Patentanspruch 1 angegebene Halterung für eine Schwingquarzscheibe bekannt, wobei zwei Blattfedern eine quadratische Schwingquarzscheibe an zwei Ecken halten und diese umgreifen. Diese Halterung weist jedoch den Nachteil auf, daß die Schwingquarzscheibe überwiegend durch die Federspannung der beiden Federn gehalten wird. Dadurch wird ein unerwünschter Druck auf die Schwingquarzscheibe ausgeübt, so daß das Resonanzverhalten stark beeinflußt wird. Wegen der unterschiedlichen Ausdehnung der Bauteile bei Temperaturänderungen wird das Resonanzverhalten zusätzlich verändert.

Ein weiterer Nachteil besteht darin, daß dünne Schwingquarzscheiben, die bei extrem hohen Frequenzen eingesetzt werden, durch diese Federspannung beschädigt werden.

Der Erfindung liegt die Aufgabe zugrunde, diese in der GB-A-588 452 beschriebene Halterung so zu verbessern, daß bei rationeller Herstellung und Montage eine weitgehend spannungsfreie und elastische Aufhängung des Schwingquarzes erreicht wird, um die Übertragung mechanischer Beanspruchungen auf die Schwingquarzscheibe durch dilathermische Kräfte weitgehend auszuschalten und Stoß- und Vibrationsbelastungen sowie hohe örtliche Spannungsbeanspruchungen von der Schwingquarzscheibe fernzuhalten und einer mechanischen Beschädigung vorzubeugen.

Diese Aufgabe wird erfindungsgemäß dadurch gelöst, daß die Schwingquarzscheibe so gehaltert ist, daß ihre Unterkante parallel zur Bodenplatte verläuft, daß die Blattfedern an den Stromdurchführungsstiften angeschweißt sind und alle vier Ecken der Schwingquarzscheibe umgreifen und daß die Blattfedern die vertikalen Seitenkanten in allen übrigen Abschnitten zur Vermeidung unerwünschter Schwingungsdämpfung freilassen.

Zweckmäßige Ausgestaltungen dieser Halterung für eine rechteckförmige Schwingquarzscheibe ergeben sich aus den Unteransprüchen.

5 Ausführungsbeispiele der Erfindung werden nachfolgend anhand von schematischen Zeichnungen näher erläutert. Es zeigen :

Figuren 1 und 2 die erste Ausführungsform der Halterung mit eingebauter im wesentlichen rechteckförmiger Schwingquarzscheibe in Seitenansicht und in Stirnansicht,

Figuren 3, 4 und 5 die zweite Ausführungsform in Seitenansicht, Stirnansicht und in einem Teilschnitt längs Linie 5-5 in Fig. 4,

Figuren 6, 7 und 8 die dritte Ausführungsform in Seitenansicht, Stirnansicht und in einem Teilschnitt längs Linie 8-8 in Fig. 7,

Figuren 9 und 10 die vierte Ausführungsform in Seitenansicht und in Stirnansicht,

Figuren 11 und 12 die fünfte Ausführungsform in Seitenansicht und in Stirnansicht.

Bei allen Ausführungsformen ist gleichermaßen eine Bodenplatte 1 vorgesehen, durch die sich zwei Stromdurchführungsstifte 2 und 3 erstrecken, die im Bereich der Bodenplatte 1 in bekannter Weise in ein Einschmelzglas eingebettet und dadurch gegenüber der Bodenplatte 1 isoliert sind. Als Werkstoff für die Stromdurchführungsstifte 2 und 3 wird im Hinblick auf die dilatherische Anpassung an das Einschmelzglas eine Ni Fe- oder Ni Fe Co- Legierung verwendet.

An das obere Ende der Stromdurchführungsstifte 2 und 3 ist gleichfalls bei allen Ausführungsformen eine Blattfeder angeschweißt, die bei den einzelnen Ausführungsformen unterschiedlich ausgebildet ist, jedoch werden bei jeder Ausführungsform identische Blattfedern verwendet, die symmetrisch zu einer in der Mitte zwischen den Stromdurchführungsstiften 2 und 3 verlaufenden senkrechten Mittellinie angeordnet sind. Da die angeschweißten Blattfedern sich nicht durch das Einschmelzglas der Bodenplatte 1 erstrecken, besteht weitgehende Freiheit hinsichtlich der Werkstoffwahl und der Stärke der Blattfedern. Vorzugsweise wird als Werkstoff Neusilber (Cu 55 Ni 18 Zn 27 = Copper alloy No. 770 nach ASTM-B-122 69) verwendet. Die Blattfedern können aber auch aus einem anderen Material hergestellt werden, beispielsweise Edelstahl X 12 Cr Ni 17.7 (Werkstoff Nr. 1.4310 nach DIN 17224).

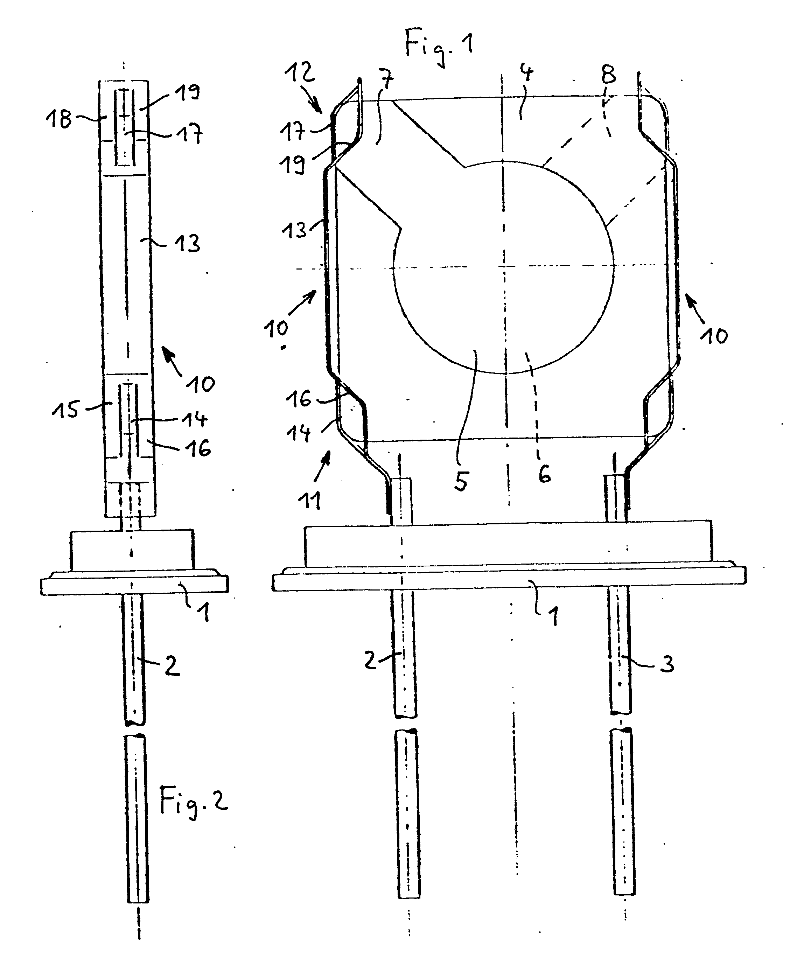

Zwischen den beiden Blattfedern ist bei den ersten fünf Ausführungsformen eine im wesentlichen quadratische Schwingquarzscheibe 4 mit abgerundeten Ecken und mit auf gegenüberliegenden Seiten der Scheibe 4 angebrachten Elektrodenflächen 5 und 6 angeordnet, an die zu den oberen Ecken der Schwingquarzscheibe 4 geführte Kontaktabschnitte 7 bzw. 8 anschließen, wie es beispielsweise aus Fig. 1 zu ersehen ist.

Bei der Ausführungsform gemäß Fig. 1 und 2 wird eine Blattfeder 10 mit einem dem Stromdurchführungsstift 2 bzw. 3 benachbarten inneren Befestigungsabschnitt 11 und einem äußeren Befestigungsabschnitt 12 verwendet. Die Befestigungsabschnitte 11 und 12, die jeweils eine Ecke der Schwingquarzscheibe 4 abstützen, sind durch einen geraden und flachen Verbindungsabschnitt 13 miteinander verbunden, der wie aus Fig. 1 ersichtlich, im Abstand zum benachbarten Rand der Schwingquarzscheibe 4 verläuft und infolge seiner Form und des für die Blattfeder 10 verwendeten Werkstoffs gute Federungseigenschaften aufweist.

Der innere Befestigungsabschnitt 11 wird von einem Mittelstreifen 14 und zwei seitlichen Randstreifen 15 und 16 gebildet, die durch Längsschnitte innerhalb der Blattfederbreite ausgebildet sind, wobei entsprechend der Darstellung in Fig. 1 der Mittelstreifen 14 nach außen ausgebogen ist und am Umfangsrand der Schwingquarzscheibe 4 anliegt, während die beiden Randstreifen 15 und 16 einwärts verlagert sind und die betreffende Ecke der Scheibe 4 auf gegenüberliegenden Seiten übergreifen. Wie dargestellt, weisen sowohl der Mittelstreifen 14 wie die Randstreifen 15 und 16 zwei im wesentlichen gerade Abschnitte auf, die mit einem Bogen ineinander übergehen. Der untere Abschnitt des Mittelstreifens 14 und die oberen Abschnitte der Randstreifen 15 und 16 verlaufen jeweils in Richtung des anschließenden Blattfederbereichs, während ihre jeweils anderen Abschnitte gegenüber dem anschließenden Blattfederbereich abgewinkelt sind.

Der obere Befestigungsabschnitt 12 der Blattfeder 10 weist eine ganz entsprechende Ausbildung mit einem am Umfangsrand der Scheibe 4 anliegenden Mittelstreifen 17 und mit zwei seitlichen Randstreifen 18 und 19 auf, welche die Schwingquarzscheibe 4 übergreifen. Dabei dient der äußere Befestigungsabschnitt 12 nicht nur der Eckaufhängung der Scheibe 4, er dient gleichzeitig der elektrischen Verbindung mit den Kontaktabschnitten 7 bzw. 8.

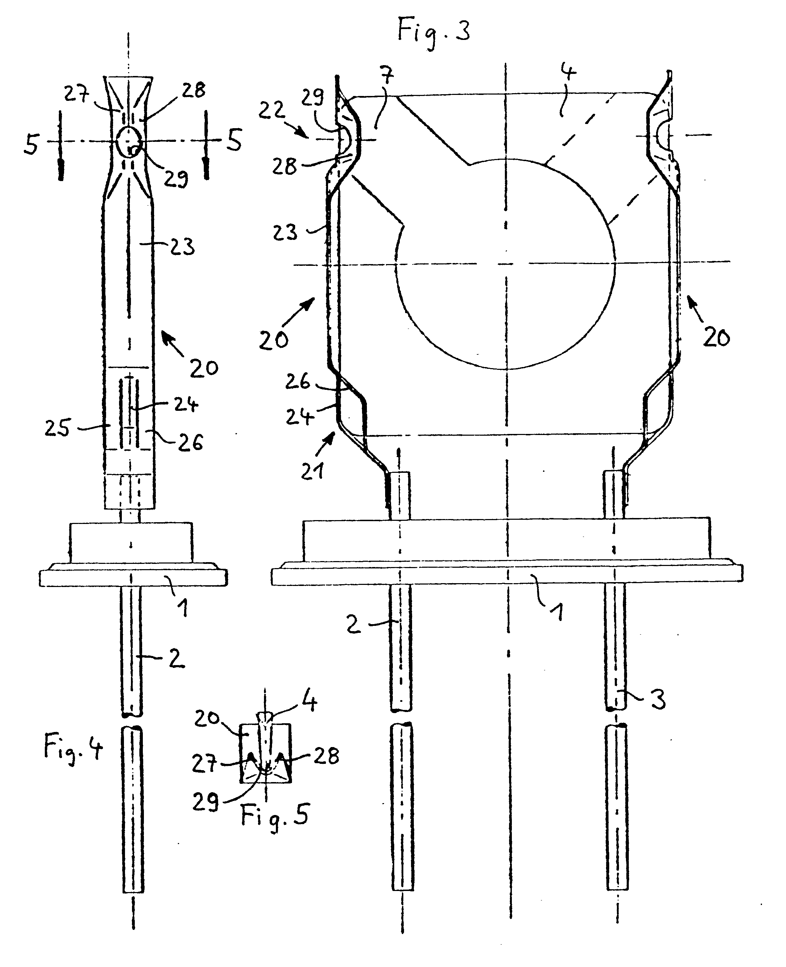

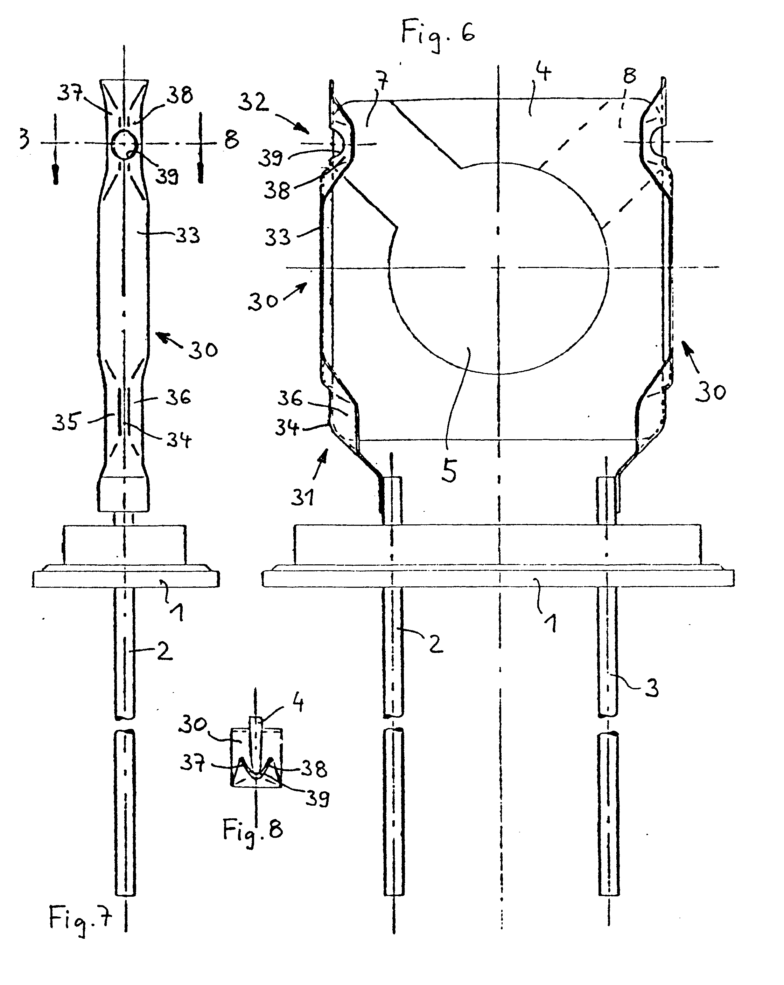

Bei der Ausführungsform gemäß Fig. 3 bis 5 ist eine Blattfeder 20 mit einem inneren Befestigungsabschnitt 21 und einem äußeren Befestigungsabschnitt 22 vorgesehen, die durch einen geraden und flachen Verbindungsabschnitt 23 miteinander verbunden sind.

Der innere Befestigungsabschnitt 21 weist einen Mittelstreifen 24 sowie Randstreifen 25 und 26 auf, wobei die Ausbildung dem Befestigungsabschnitt 11 gemäß Fig. 1 und 2 entspricht. Dagegen weist der äußere Befestigungsabschnitt 22 zwei zur Scheibe 4 hin abgewinkelte Randstreifen 27 und 28 auf, die gemäß Fig. 5 ein V-Profil bilden, in dessen Scheitelbereich der Umfangsrand der Schwingquarzscheibe 4 anliegt. In der Mitte des Befestigungsabschnitts 22 weist die Blattfeder 20 eine durchgehende Öffnung 29 auf, in die nach dem montageleichten Einschieben der Schwingquarzscheibe 4 zwischen die beiden Blattfedern 20 ein Leitkitt eingebracht wird, der nicht nur den Kontakt zwischen der Blattfeder 20 und dem Kontaktabschnitt 7 bzw. 8 sichert, sondern zusätzlich zur mechanischen Bewegungsbegrenzung der vier Scheibenecken durch die Befestigungsabschnitte 21 und 22 die oberen Scheibenecken fixiert.

Bei der dritten Ausführungsform gemäß Figuren 6 bis 8 ist eine Blattfeder 30 mit einem inneren Befestigungsabschnitt 31 und einem äußeren Befestigungsabschnitt 32 vorgesehen, die durch einen geraden Verbindungsabschnitt 33 miteinander verbunden sind, der wiederum mit gleichbleibendem Abstand zur benachbarten Scheibenkante verläuft.

Der untere Befestigungsabschnitt 31 weist zwei einwärts abgewinkelte Wangen oder Randstreifen 35 und 36 auf, die in einen Scheitelbereich 34 übergehen. Wie aus Fig. 6 zu ersehen, verläuft der Scheitelbereich 34 in der Längsrichtung in Anpassung an die gerundete Scheibenecke und geht unter Abhebung vom Scheibenumfang in den Verbindungsabschnitt 33 über.

Der äußere Befestigungsabschnitt 32 ist wie der Befestigungsabschnitt 22 der zweiten Ausführungsform ausgebildet und mit seitlichen Wangen oder Randstreifen 37 und 38 sowie mit einer durchgehenden Öffnung 39 versehen.

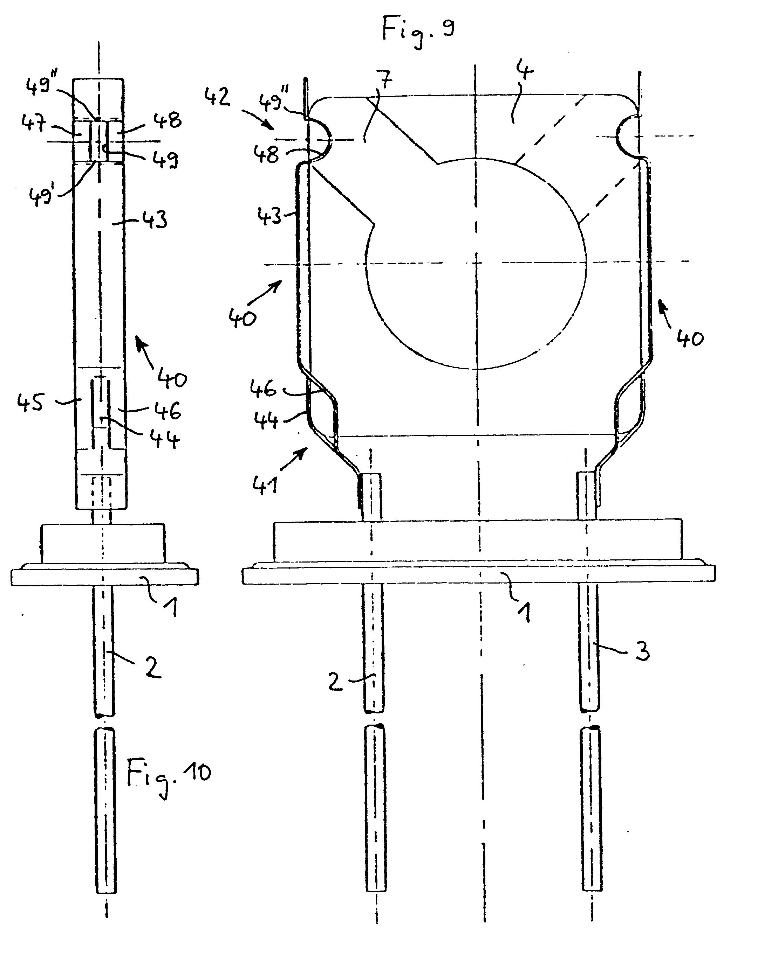

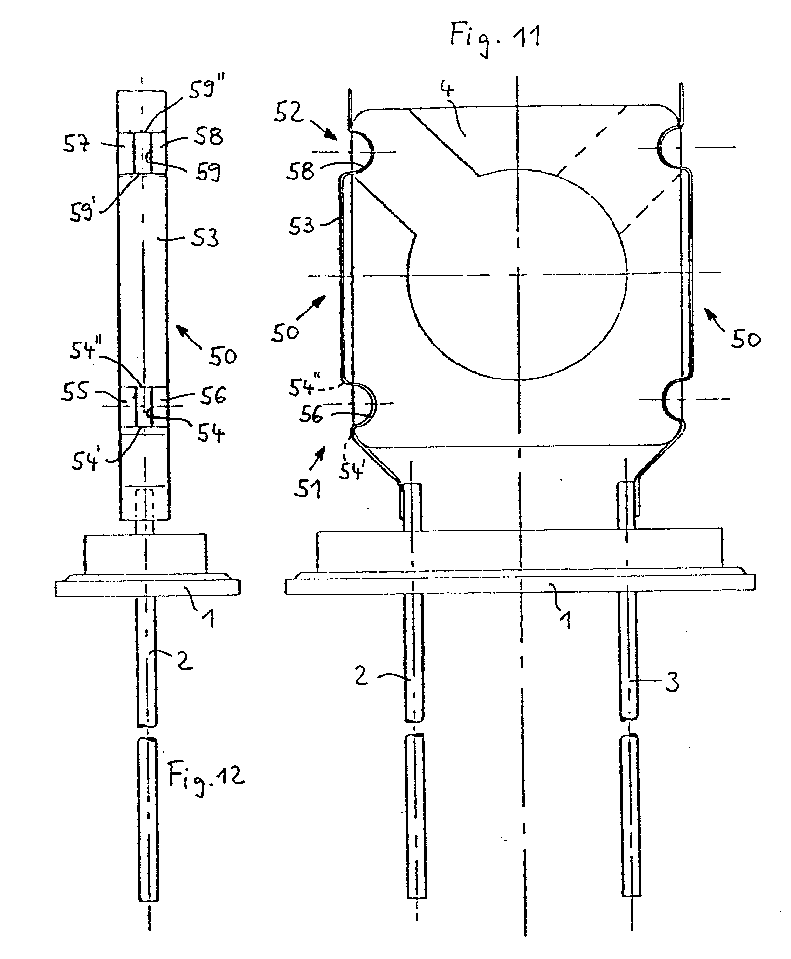

Die vierte Ausführungsform ist in Figuren 9 und 10 dargestellt. Sie weist eine Blattfeder 40 mit einem inneren Befestigungsabschnitt 41 und einem äußeren Befestigungsabschnitt 42 auf, die durch einen sich im Abstand zur benachbarten Scheibenkante erstreckenden geraden und flachen Verbindungsabschnitt 43 miteinander verbunden sind.

Der innere Befestigungsabschnitt 41 ist wie der innere Befestigungsabschnitt 11 gemäß Fig. 1 und 2 mit einem Mittelstreifen 44 und zwei seitlichen Randstreifen 45 und 46 ausgebildet. Der äußere Befestigungsabschnitt 42 ist mit zwei seitlichen Randstreifen 47 und 48 versehen, die zwischen sich einen Längsschlitz 49 begrenzen. Die Randstreifen 47 und 48 sind gemäß Fig. 9 etwa halbkreisförmig in Richtung auf die Scheibe 4 ausgebogen. Der Längsschlitz 49 ist an seinen Enden mit Stanzkanten 49′ und 49″ versehen, die außerhalb des ausgebogenen Bereichs angeordnet sind und daher nicht die (alleinige) Anlage für den Umfangsrand der Scheibe 4 bilden. Auch diese Ausbildung des Befestigungsabschnitts 42 ermöglicht ein montagefreundliches Einschieben der Schwingquarzscheibe 4 zwischen die beiden Blattfedern 40. Der Leitkitt zum Fixieren der Scheibe 4 wird innerhalb des von den Randstreifen 47 und 48 gebildeten Bogens aufgebracht.

Die fünfte Ausführungsform gemäß Figuren 11 und 12 weist eine Blattfeder 50 mit einem inneren Befestigungsabschnitt 51 und einem äußeren Befestigungsabschnitt 52 auf, die wiederum durch einen geraden und flachen Verbindungsabschnitt 53 miteinander verbunden sind.

Der innere Befestigungsabschnitt 51 weist zwei seitliche Randstreifen 55 und 56 auf, zwischen denen ein Längsschlitz 54 ausgebildet ist. Die Randstreifen 55 und 56 sind etwa halbkreisförmig zur Scheibe 4 hin ausgebogen. Die Stanzkanten 54′ und 54″ an den Enden des Längsschlitzes 54 sind wiederum soweit außerhalb des Bogenbereichs der Randstreifen 55 und 56 angeordnet, daß sie nicht auf den Scheibenrand drücken.

Der äußere Befestigungsabschnitt 52 ist wie der äußere Befestigungsabschnitt 42 gemäß Fig. 9 und 10 ausgebildet und weist dementsprechend zwei seitliche Randstreifen 57 und 58 sowie einen Längsschlitz 59 mit Stanzkanten 59′ und 59″ an seinen Enden auf.

**Patentansprüche**

1. Halterung für eine im wesentlichen rechteckige Schwingquarzscheibe (4), bestehend aus einer Bodenplatte (1) mit zwei Stromdurchführungsstiften (2, 3), an deren oberen Enden jeweils eine aufragende Blattfeder (10 ; 20 ; 30 ; 40 ; 50) befestigt ist, welche die Schwingquarzscheibe (4) in einem Randbereich auf gegenüberliegenden Seiten der Scheibenebene übergreifen und dadurch ihre Bewegungen in der und quer zur Scheibenebene begrenzen, dadurch gekennzeichnet, daß die Schwingquarzscheibe (4) so gehaltert ist, daß ihre Unterkante parallel zur Bodenplatte (1) verläuft, daß die Blattfedern an den Stromdurchführungsstiften (2, 3) angeschweißt sind und alle vier Ecken der Schwingquarzscheibe (4) umgreifen und daß die Blattfedern die vertikalen Seitenkanten in allen übrigen Abschnitten zur Vermeidung unerwünschter Schwingungsdämpfung freilassen.

2. Halterung nach Anspruch 1, dadurch gekennzeichnet, daß die Blattfedern in mindestens zwei der Bereiche, mit denen sie die Ecken der Schwingquarzscheibe (4) umgreifen, Mittelstreifen (14, 17, 24, 44) aufweisen, die an den Ecken der Schwingquarzscheibe anliegen.

3. Halterung nach Anspruch 1, dadurch gekennzeichnet, daß die Blattfedern (20, 30) in den Bereichen, mit denen sie die oberen Eckbereiche der Schwingquarzscheibe (4) umgreifen, ein V-förmiges Profil mit einwärts abgewinkelten Randstreifen (27, 28 ; 35, 36 ; 37, 38) und mit einem am Umfangsrand der Scheibe (4) anliegenden Scheitelbereich (34) aufweisen.

4. Halterung nach einem der Ansprüche 1 bis 3, dadurch gekennzeichnet, daß die Blattfedern in den Bereichen, mit denen sie die oberen Eckbereiche der Schwingquarzscheibe (4) umgreifen, einen Leitkitt aufweisen.

5. Halterung nach Anspruch 4, dadurch gekennzeichnet, daß dieser Leitkitt zur Begrenzung der Dämpfung in Öffnungen (29, 39) angebracht ist, die in diesem Scheitelbereich (34) angeordnet sind.

## Claims

1. A mounting for a substantially rectangular quartz resonator plate (4) consisting of a base plate (1) with two current supply pins (2, 3) on whose upper ends there is fastened a respective projecting leaf spring (10, 20, 30, 40, 50), which overlap the quartz resonator plate (4) in an edge area on opposite sides of the plane of the plate and thereby limit its movements in the plane and transverse to the plane of the plate, characterised in that the quartz resonator plate (4) is mounted in such a way that its lower edge extends parallel to the base plate (1), in that the leaf springs are soldered to the current supply pins (2, 3) and overlap all four corners of the quartz resonator plate (4) and in that the leaf springs leave all the remaining sections of the vertical side edges free in order to prevent undesirable damping of vibrations.

2. A mounting as claimed in claim 1, characterised in that the leaf springs comprise central strips (14, 17, 24, 44) in at least two of the areas in which they overlap the corners of the quartz resonator plate (4), which strips lie on the corners of the quartz resonator plate.

3. A mounting as claimed in claim 1, characterised in that the leaf springs (20, 30) have a V-shaped profile with inwardly angled edge strips (27, 28 ; 35, 36 ; 37, 38) and with a top area (34) lying on the peripheral edge of the plate (4) in the areas in which they overlap the upper corner areas of the quartz resonator plate (4).

4. A mounting as claimed in one of claims 1 to 3, characterised in that the leaf springs are provided with a conductive cement in the areas in which they overlap the upper corner areas of the quartz resonator plate (4).

5. A mounting as claimed in claim 4, characterised in that this conductive cement is applied in apertures (29, 39) in order to limit the damping, which apertures are provided in the top area (34).

## Revendications

1. Support pour un disque (4) essentiellement rectangulaire d'un cristal oscillateur, constitué par une plaque de base (1) comportant deux broches (2, 3) d'amenée du courant et sur les extrémités supérieures desquelles se trouvent fixés des ressorts à lames respectifs (10 ; 20 ; 30 ; 40 ; 50) qui s'étendent vers le haut et sont en saillie par rapport au disque (4) du cristal oscillateur, dans une zone marginale, sur des côtés opposés du plan du disque, et limitent de ce fait les déplacements du disque dans son plan et transversalement par rapport à son plan, caractérisé en ce que le disque (4) du cristal oscillateur est maintenu de telle sorte que son bord inférieur est parallèle à la plaque de base (1), que les ressorts à lames sont soudés sur les broches (2, 3) d'amenée du courant et entourent l'ensemble des quatre angles du disque (4) du cristal oscillateur et que les ressorts à lames laissent dégagés les bords latéraux verticaux dans l'ensemble des autres sections afin d'éviter un amortissement indésirable de l'oscillation.

2. Support selon la revendication 1, caractérisé en ce que les ressorts à lames comportent, dans au moins deux des zones avec lesquelles ils enserrent les angles du disque (4) du cristal oscillateur, des bandes médianes (14, 17, 24, 44) qui sont appliquées sur les angles du disque du cristal oscillateur.

3. Support selon la revendication 1, caractérisé en ce que les ressorts à lames (20, 30) comportent, dans les zones avec lesquelles ils enserrent les zones d'angle supérieures du disque (4) du cristal oscillateur, un profil en forme de V comportant des bandes marginales (27, 28 ; 35, 36 ; 37, 38) recourbées de manière à être rentrantes et une partie en forme de pointe (34) s'appliquant contre le bord périphérique du disque (4).

4. Support selon l'une des revendications 1 à 3, caractérisé en ce que les ressorts à lames comportent un ciment conducteur dans les zones avec lesquelles les ressorts à lames entourent les zones d'angle supérieures du disque (4) du cristal oscillateur.

5. Support selon la revendication 4, caractérisé en ce que ce ciment conducteur est placé, afin de limiter l'amortissement, dans des ouvertures (29, 39) qui sont disposées dans cette partie en forme de pointe (34).

Fig. 1

Fig. 2

Fig. 3

Fig. 4

Fig. 5

Fig. 6

Fig. 7

Fig. 8

Fig. 9

Fig. 10

Fig. 11

Fig.12